# FASCICULE DE BREVET EUROPEEN

(11) **EP 2 131 495 B1**
(45) Date de publication et mention de la délivrance du brevet: **23.03.2011**
(21) Numéro de dépôt: 09354020.1
(22) Date de dépôt: 26.05.2009
(51) Int. Cl.: H03K 5/13

(54) **Circuit asynchrone insensible aux délais avec circuit d'insertion de délai**
Verzögerungsunempfindlicher asynchroner Schaltkreis mit Verzögerungseinschaltschaltkreis
Asynchronous circuit not sensitive to delays with delay insertion circuit

(30) Priorité: 06.06.2008 FR 0803165
(43) Date de publication de la demande: 09.12.2009
(73) Titulaire: Tiempo, F-38330 Montbonnot St-Martin (FR)
(72) Inventeur: Renaudin, Marc, 38330 Biviers (FR); Bouesse, Ghislain, 38240 Meylan (FR)
(74) Mandataire: Hecké, Gérard

(56) Documents cités:
- EP-A- 0 913 768
- US-B2- 7 205 794
- SUTHERLAND I E: "MICROPIPELINES" COMMUNICATIONS OF THE ASSOCIATION FOR COMPUTING MACHINERY, ACM, NEW YORK, NY, US, vol. 32, no. 6, 1 juin 1989 (1989-06-01), pages 720-738, XP000256681 ISSN: 0001-0782

## Description

### Domaine technique de l'invention

L'invention est relative à un circuit asynchrone insensible aux délais comportant, sur le chemin de propagation d'un signal, au moins un circuit d'insertion de délai.

### État de la technique

Un circuit électronique de traitement de signal exerce sur un signal d'entrée diverses opérations le modifiant. En cryptographie, la valeur du signal de sortie d'un circuit de traitement est codée de manière à ce que personne ne puisse accéder à l'information en dehors de personnes autorisées. Cependant, l'étude des canaux cachés (consommation, rayonnements électromagnétiques, délais) des circuits électroniques peut permettre de déterminer les opérations effectuées par le circuit sur le signal. De tels types d'attaques mettent en danger l'intégrité et la confidentialité des informations. Classiquement, des circuits ont été élaborés avec des contre-mesures rendant plus difficiles les attaques sur l'étude de la consommation des circuits.

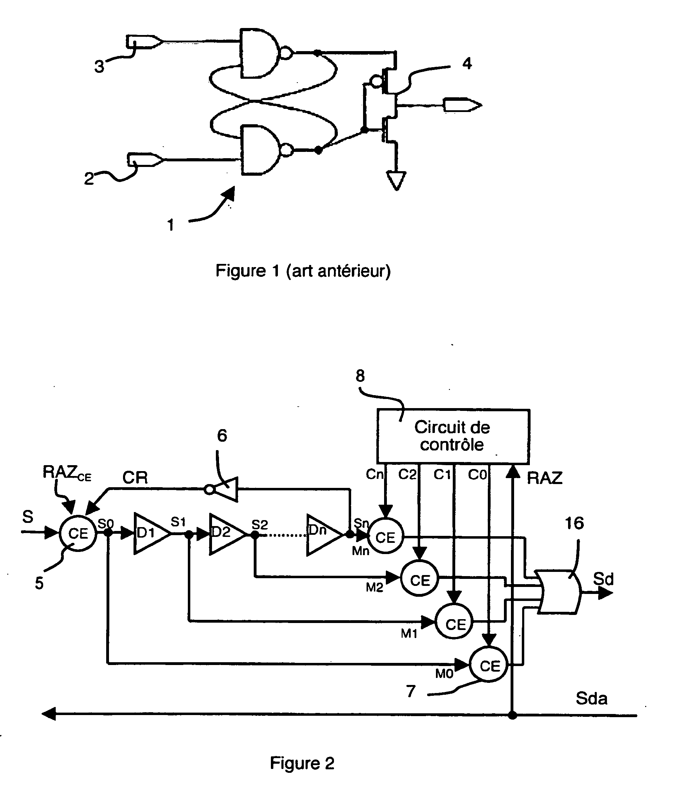

Le brevet US 7205794 décrit un microprocesseur résistant à une analyse de puissance, utilisant un circuit d'insertion d'un délai aléatoire illustré à la figure 1. Le circuit comporte une bascule 1, de type RS. Sur la figure 1, la bascule comporte deux portes logiques NON-ET ayant chacune une première entrée connectée à la sortie de l'autre. Les données sont appliquées sur une seconde entrée 2 de la première porte, constituant une entrée de données du circuit. Des bits de valeur aléatoire sont appliqués sur une seconde entrée 3 de la seconde porte, constituant une entrée aléatoire du circuit. Un filtre est connecté à la sortie de la bascule. Ce filtre comporte deux transistors respectivement de type P-MOS et N-MOS reliés en série entre la sortie de la seconde porte et la masse. Les grilles des deux transistors sont connectées directement à la sortie de la première porte. On obtient ainsi, à la sortie du circuit, constitué par le point commun aux deux transistors, des signaux de données retardés de façon aléatoire.

Le brevet US 6327661 décrit, dans le domaine de la cryptographie un type de contre-mesure agissant sur une horloge interne du circuit en sautant certains cycles d'horloge (« clock skipping » en anglais) de manière aléatoire. Le saut aléatoire de cycles d'horloge peut aussi être réalisé de manière logicielle. Ce type de contre-mesure n'est applicable qu'à des circuits synchrones.

La demande de brevet WO2006/100626 décrit un circuit électronique dans lequel est réalisé un délai asynchrone. Un signal d'entrée arrive sur une entrée d'un circuit de contrôle, à l'arrivée de ce signal, le circuit de contrôle génère une pluralité de signaux qui sont ensuite envoyés successivement à un circuit d'insertion de délai. Lorsque le nombre de signaux traités par le circuit de délai est égal à un nombre prédéterminé, le circuit de contrôle fournit une réponse au signal d'entrée. Le circuit d'insertion de délai utilise le même circuit de délai basique qui est activé une pluralité de fois avant que le circuit de contrôle fournisse une réponse au signal d'entrée. Une étude de la consommation en énergie de ce type de circuit permet de connaître à l'avance le délai de propagation du signal d'entrée. De plus, la valeur du délai dépend du nombre prédéterminé et ne peut être modifié dynamiquement.

### Objet de l'invention

L'objet de l'invention consiste à réaliser un circuit asynchrone insensible aux délais n'ayant pas les inconvénients de l'art antérieur et pouvant résister aux attaques.

Ce but est atteint par le fait que le circuit d'insertion de délai comporte entre une entrée et une sortie du signal, une porte de Muller et une pluralité de circuits à retard connectés en série à une sortie de la porte de Muller, chaque circuit à retard comportant une sortie étant connectée à une entrée correspondante d'un circuit de multiplexage, une sortie du circuit de multiplexage constituant la sortie du circuit d'insertion de délai, ladite porte de Muller comportant une entrée constituant l'entrée du circuit d'insertion de délai et une entrée connectée, par l'intermédiaire d'une porte inverseuse, à la sortie du dernier circuit de retard.

Selon un mode de réalisation, le circuit asynchrone comporte au moins des premier et second circuits d'insertion de délai connectés en série, la sortie du premier circuit d'insertion de délai étant connectée à l'entrée du second circuit d'insertion de délai, la sortie du second circuit d'insertion de délai étant connectée à au moins une entrée de blocage du circuit de multiplexage du premier circuit d'insertion de délai.

Selon un autre mode de réalisation, le circuit asynchrone comporte au moins deux circuits d'insertion de délai, les circuits de multiplexage des deux circuits d'insertion de délai étant reliés à un unique circuit de contrôle.

Selon un troisième mode de réalisation, le circuit asynchrone comporte plusieurs signaux de données indépendants, chaque signal étant connecté à une entrée d'un circuit d'insertion de délai unique et à une première entrée d'une porte de Muller additionnelle correspondante, la sortie dudit circuit d'insertion de délai étant reliée à une seconde entrée de chaque porte de Muller additionnelle.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 illustre un circuit avec insertion d'un délai aléatoire selon l'art antérieur.
La figure 2 illustre un circuit d'insertion de délai dans un circuit asynchrone insensible aux délais selon l'invention.
Les figures 3 et 4 illustrent de variantes de réalisation de circuit à retard d'un circuit d'insertion selon la figure 2.
La figure 5 illustre un circuit d'insertion de délai en structure de pipe-line à deux étages.
La figure 6 illustre une variante de réalisation d'une structure de pipe-line selon la figure 5
La figure 7 illustre un circuit d'insertion de délai dans un circuit asynchrone multi-rail.
La figure 8 illustre une application d'un retard à plusieurs canaux avec mutualisation du contrôleur.

### Description de modes préférentiels de réalisation

Dans le mode de réalisation illustré à la figure 2, le circuit asynchrone insensible aux délais comporte un circuit d'insertion de délai situé sur le chemin de propagation d'un signal S. Le circuit d'insertion de délai comporte entre une entrée S et une sortie Sd du signal une porte de Muller 5 (CE, « C-Element en anglais ») et une pluralité de circuits à retard D1 à Dn connectés en série à la sortie S0 de la porte de Muller 5, la sortie S0 étant reliée à l'entrée du circuit à retard D1. Les sorties respectives S1 à Sn des circuits à retard D1 à Dn sont connectées à des entrées correspondantes M1 à Mn d'un circuit de multiplexage, ayant une sortie qui constitue la sortie Sd du circuit d'insertion de délai. La porte de Muller 5 comporte une première entrée constituant l'entrée du circuit d'insertion de délai et sur laquelle est appliqué le signal à traiter. Une seconde entrée de la porte de Muller 5 est reliée à la sortie Sn du dernier circuit à retard Dn par l'intermédiaire d'une porte inverseuse 6, de manière à recevoir un signal de contre-réaction CR.

Les circuits à retard peuvent être de tout type connu et, en particulier, comporter une suite de portes logiques ou analogiques (charge et décharge de capacité, par exemple) retardant les signaux appliqués à leur entrée sans les modifier.

La table de vérité d'une porte de Muller à deux entrées, aussi appelée porte majorité, est classiquement la suivante :

| | | |
|---|---|---|
| x | y | z |
| 0 | 0 | 0 |
| 0 | 1 | Z₋₁ |
| 1 | 1 | 1 |
| 1 | 0 | Z₋₁ |

x et y représentant les entrées de la porte et z la sortie. Ainsi, lorsque les signaux d'entrée (x et y) de la porte de Muller sont identiques, la porte est passante et le signal de sortie est identique à celui des entrées. Par contre, lorsque les signaux d'entrée de la porte sont différents, alors la porte est bloquante et la sortie reste inchangée (z=z₋₁).

Le circuit d'insertion de délai permet d'introduire un retard dans le circuit asynchrone. Le retard est programmable dynamiquement entre une valeur Min et une valeur Max pour un nombre P fini de valeurs possibles dépendant du nombre de circuits à retard. Les valeurs Min, Max et P sont fixées à la conception du circuit. La valeur Min correspond au délai de propagation minimal d'une transition dans le circuit d'insertion de délai. La valeur Max correspond au délai maximum pouvant séparer deux transitions successives différentes à la sortie du circuit d'insertion de délai. La valeur Max dépend du nombre de circuits à retard constituant le circuit d'insertion de délai et correspond à la somme des délais individuels D1 à Dn des différents circuits à retard. Deux transitions successives différentes pouvant transiter dans le circuit insensible aux délais sont séparées au moins par une période égale à la valeur Max.

Si l'on néglige le délai de transmission de la porte de Muller 5, la valeur Min est égale à la valeur du délai du premier circuit à retard D1. Elle peut être nulle, comme dans la variante illustrée à la figure 2 dans laquelle la sortie S0 de la porte de Muller 5 est reliée non seulement à l'entrée du premier circuit à retard D1, mais également à une entrée M0 du circuit de multiplexage.

Le circuit de multiplexage peut comporter au moins une entrée de contrôle correspondant à une sortie C0..Cn d'un circuit de contrôle définissant le signal à propager.

À titre d'exemple, le circuit de multiplexage de la figure 2 est réalisé à base de portes de Muller. Chaque entrée M0, M1..Mn, du circuit de multiplexage correspond à une entrée d'une porte de Muller 7 distincte. Chaque porte de Muller 7 comporte une autre entrée, constituant une entrée de contrôle du circuit de multiplexage et reliée à une sortie correspondante C0, C1..Cn d'un circuit de contrôle 8 du circuit de multiplexage. Ainsi, afin de permettre la propagation d'une transition, par exemple montante, avec un retard choisi parmi P valeurs possibles comprises entre les valeurs Min et Max, le circuit de contrôle met à 1 l'une de ses sorties C0, C1..Cn, les autres étant mises à 0.

Les sorties des portes de Muller 7 sont connectées à des entrées correspondantes d'une porte logique 16 (type OU) et dont la sortie constitue la sortie du circuit de multiplexage.

À titre d'exemple, dans le mode de réalisation de la figure 2, tous les signaux de contrôle C0 à Cn sont initialement mis à zéro. Ceci peut être réalisé dans une phase d'initialisation à l'aide d'un signal de remise à zéro appliqué à une entrée RAZ de remise à zéro du circuit de contrôle 8. En faisant l'hypothèse que le signal d'entrée S est initialement à l'état bas (0). Seul le signal de contre-réaction CR est alors à 1. La valeur de la sortie de la porte de Muller 5 dépendant de la valeur du dernier signal propagé par cette dernière, la porte de Muller 5 comporte de préférence une entrée de remise à zéro RAZ_{-CE}, cette entrée de remise à zéro de la porte de Muller 5 permet d'initialiser le circuit d'insertion de délai en mettant à 0 la sortie S0 de la porte de Muller 5, la propagation de ce signal 0 dans le circuit d'insertion de délai permet de s'assurer que le signal CR est mis à 1 et permet de connaître tous les états en sortie et en entrée des différentes portes et circuits à retard du circuit d'insertion de délai. En effet, lorsque la propagation de la transition 0 atteint le dernier circuit à retard Dn, la transition descendante 0 est propagée à l'entrée de l'inverseur 6 faisant ainsi passer le signal de contre-réaction CR à 1. Une transition montante du signal d'entrée S peut alors être propagée par la porte de Muller 5 (S0=1), puis successivement par les circuits à retard D1 à Dn. Les signaux S0 à Sn prennent alors successivement la valeur 1. Après l'initialisation, et de préférence avant la propagation du signal S à la porte de Muller 5 d'entrée du circuit d'insertion de délai, le circuit de contrôle 8 du circuit de multiplexage met à 1 une seule de ses sorties C0 à Cn, les autres restant à 0. Chaque circuit à retard transmet ainsi la transition montante du signal d'entrée à l'entrée correspondante M1 à Mn du circuit de multiplexage et au circuit à retard suivant (D2 à Dn). Lorsque le dernier circuit à retard Dn est atteint, il propage la transition montante à l'entrée de l'inverseur 6 faisant ainsi passer le signal de contre-réaction CR à 0. Tant que le signal de contre-réaction CR est à 1, il verrouille la propagation d'une transition descendante par la porte de Muller 5. Son passage à 0, uniquement après propagation de la transition montante jusqu'à la sortie Sn du dernier circuit à retard, permet ensuite la propagation d'une transition descendante dans le circuit d'insertion de délai. Une transition montante ultérieure ne pourra être transmise qu'après propagation de la transition descendante précédente à travers le circuit d'insertion de délai et passage à 1 du signal de contre-réaction CR. Le signal de contre-réaction CR assure ainsi le traitement des transitions à l'entrée S du circuit d'insertion de délai avec un intervalle de temps supérieur ou égal à la valeur MAX et rend le circuit d'insertion de délai quasi-insensible aux délais. La durée du délai introduit par le circuit d'insertion de délai est fonction du signal de contrôle (C0 à Cn) mis à 1, pour une transition montante, ou à 0, pour une transition descendante, par le circuit de contrôle 8 du circuit de multiplexage. Le signal Sd de sortie du circuit de multiplexage correspond en effet au signal appliqué à l'entrée du circuit de multiplexage dont le signal de contrôle (associé à C0..Cn) est mis à 1 dans le cas de la propagation d'une transition montante.

Afin d'assurer un meilleur contrôle du circuit d'insertion de délai, lorsqu'une transition est propagée à la sortie Sd du circuit d'insertion de délai, un signal d'acquittement Sda peut être généré dans le circuit asynchrone et appliqué à l'entrée RAZ de mise à zéro du circuit de contrôle 8 du circuit de multiplexage pour modifier l'état de ses sorties C0 à Cn afin de permettre la propagation d'une nouvelle transition selon un délai pouvant être différent du délai précédent. Le signal d'acquittement Sda est, de préférence, également appliqué au circuit asynchrone en amont du circuit d'insertion de délai pour permettre l'envoi, par le circuit asynchrone, d'une nouvelle transition du signal d'entrée S à l'entrée du circuit d'insertion de délai.

Le circuit d'insertion de délai permet de retarder les transitions du signal d'entrée S ou de plusieurs signaux tout en gardant une consommation d'énergie constante, c'est-à-dire que quel que soit le temps de retard du signal retardé Sd, la quantité d'énergie consommée par le circuit d'insertion de délai est la même. Cette consommation constante est importante dans le cadre d'une utilisation dans le domaine de la sécurité et du chiffrement. En effet, il est très difficile de déterminer la valeur du retard en étudiant la consommation en courant du circuit d'insertion de délai.

L'insertion de ce retard dans un circuit numérique asynchrone insensible aux délais permet néanmoins de modifier la consommation en courant en fonction du temps de l'ensemble du circuit asynchrone comportant le circuit d'insertion de délai, sans pour autant créer des dysfonctionnements dans le traitement des données.

Modifier la consommation d'un circuit présente des avantages, notamment dans les domaines de la réduction de bruit et de la cryptographie.

Ainsi, l'insertion d'un retard variable dans le traitement d'un signal dans un circuit asynchrone permet de réduire le bruit généré (dans le substrat, rayonnement électromagnétique, etc.) en lissant la consommation en courant du circuit et en réduisant les pics de courant dont l'occurrence peut entraîner des erreurs de calcul ou endommager le circuit. Cette utilisation est intéressante notamment dans les domaines de l'automobile, de l'avionique, et du médical.

Le circuit de contrôle 8 du circuit de multiplexage peut comporter un générateur aléatoire destiné à permettre un choix aléatoire du retard à appliquer au signal S avant sa propagation dans le circuit asynchrone à la sortie Sd du circuit d'insertion de délai. Ainsi, lorsque le circuit de contrôle du circuit de multiplexage est muni d'un générateur aléatoire, ou pseudo-aléatoire, cela permet une consommation en courant aléatoire ou pseudo-aléatoire du circuit asynchrone. La consommation aléatoire ou pseudo aléatoire permet de protéger le circuit asynchrone contre les attaques en puissance ou les attaques électromagnétiques.

En effet, le courant circulant dans un circuit induit un rayonnement électromagnétique au voisinage du circuit. La consommation d'un circuit variant pendant le traitement des données, une analyse de puissance ou une analyse électromagnétique de ce circuit peut permettre l'extraction de données secrètes ou du moins confidentielles.

De manière connue, des analyses de type analyse de puissance seule (« SPA » ou « Single Power Analysis » en anglais, ainsi que ses dérivés), dite « par canaux cachés » (du terme anglais « Side Channel »), consiste à observer les variations de la consommation globale en puissance électrique du circuit et ensuite à identifier les données. Ce type d'analyse donne de meilleurs résultats si l'architecture matérielle « hardware » est connue. À titre d'exemple, une augmentation de la consommation du circuit peut indiquer qu'une opération d'exponentiation modulaire est en cours.

Une analyse de puissance différentielle (DPA pour « Differential Power Analysis » en anglais, ainsi que ses dérivés comme la CPA et la DPA d'ordre supérieur), également dite « par canaux cachés », est plus sophistiquée que la précédente. Elle est basée sur une analyse statistique. Plusieurs exécutions du même algorithme permettent l'extraction statistique de l'information convoitée.

Une attaque par analyse électromagnétique différentielle (DEMA pour ≪ Differential Electromagnetic Analysis ≫ en anglais, et ses dérivées), est basée sur les mêmes techniques que les analyses de type SPA et DPA, mais les quantités physiques mesurées sont différentes. Dans le cas des attaques DEMA, ce sont les rayonnements électromagnétiques émis par les pistes du circuit qui sont visés.

Un autre type d'attaque, de type électromagnétique, consiste à positionner une sonde à proximité de la surface du circuit et à mesurer localement le champ magnétique afin de déduire les signaux circulant au voisinage de cette sonde.

L'insertion aléatoire de délai dans un circuit asynchrone permet de constituer une barrière contre les attaques étudiant la consommation et les rayonnements électromagnétiques d'un circuit. Ceci est, en particulier, intéressant dans des boucles de traitement tels que des calculs arithmétiques, des machines à état, des microprocesseurs ou microcontrôleurs, des circuits de chiffrement comme l'algorithme standard de chiffrement de données (DES pour ≪ Data Encryption Standard ≫en anglais), l'algorithme avancé de chiffrement (AES pour ≪ Advanced Encryption Standard ≫ en anglais) ou encore l'algorithme de Rivest, Shamir et Adleman (RSA), etc.

Selon une variante de réalisation, chaque circuit à retard Di (D1 à Dn) du circuit d'insertion de délai peut propager un signal avec un retard de manière symétrique ou asymétrique. Bien entendu, dans un même circuit d'insertion de délai, il est possible d'avoir des circuits à retard asymétrique et des circuits à retard symétriques.

Un retard est dit symétrique lorsqu'il retarde de la même manière une transition montante et une transition descendante.

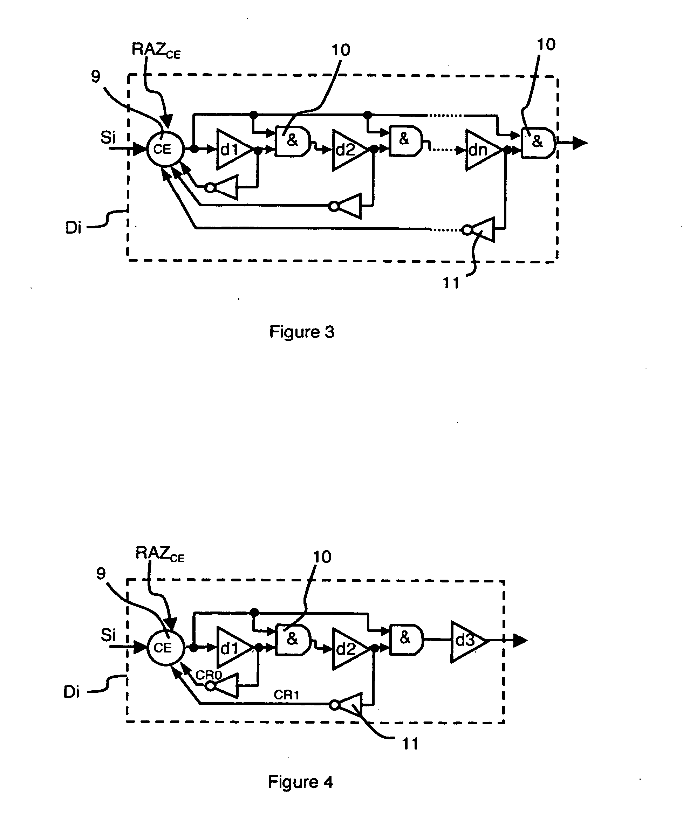

Un retard est dit asymétrique lorsque les transitions montantes et descendantes sont retardées de manières différentes. Ainsi, à titre d'exemple, un circuit à retard Di, asymétrique, comporte, comme illustré à la figure 3, une entrée Si constituée par une entrée d'une porte de Muller 9 comportant une entrée de remise à zéro RAZ_{CE} du signal de sortie de la porte de Muller 9 ayant les mêmes fonctions que l'entrée de remise à zéro de la porte de Muller 5 d'entrée du circuit d'insertion de délai. La sortie de la porte de Muller 9 est reliée directement à une première entrée d'une porte ET 10 et à une deuxième entrée de la porte logique ET 10 par l'intermédiaire d'une cellule de retard d1 (porte logique élémentaire ou capacité, par exemple). Le circuit à retard Di peut comporter une pluralité de portes 10, reliées en série, ayant chacune une première entrée reliée à la sortie de la porte de Muller 9. Une deuxième entrée de chaque porte 10 est reliée à la sortie de la porte précédente (porte de Muller 9 pour la première porte 10, porte 10 précédente pour les autres) par l'intermédiaire d'une cellule à retard (d1..dn). La sortie de chaque cellule à retard (d1..dn) est connectée à une entrée correspondante de la porte de Muller 9 par l'intermédiaire d'un inverseur 11 correspondant. La sortie de la dernière porte 10 constitue la sortie du circuit à retard Di. Ainsi, pour les transitions descendantes du signal d'entrée (Si), le retard est quasi-nul (le signal de sortie de la porte de Muller 9 appliquant un signal 0 à la première entrée de chaque porte 10, provoquent ainsi le passage à 0 de la sortie de la dernière porte 10) et ne dépend que des retards intrinsèques de propagation de la porte de Muller et de la porte ET, alors que pour les transitions montantes, le retard est égal à la somme des délais correspondant aux cellules d1 à dn. Selon une variante illustrée à la figure 4, seules trois portes logiques (d1, d2, d3) sont représentées et il n'y a pas de contre-réaction entre la sortie de la porte de d3 et la porte de Muller D9, et la sortie du circuit à retard Di est constituée par la sortie de la cellule à retard d3. Dans ce cas, le circuit à retard retarde de d1+d2+d3 les transitions montantes et de d3 les transitions descendantes.

Dans les exemples de réalisation de cellules à retard à délai asymétriques des figures 3 et 4, il y a parallélisation du traitement d'une transition descendante. En effet, une transition descendante se propage simultanément à la première entrée de toutes les portes 10 et successivement, à l'entrée de chaque cellule à retard (d1..dn). Les contre-réactions vers les entrées de la porte de Muller 9 permettent d'assurer la quasi-insensibilité aux délais, et permet de ne pas laisser passer une nouvelle transition tant que la transition précédente circule encore dans le circuit à retard. Dans les deux cas, la consommation d'énergie reste constante, indépendamment des valeurs choisies pour les délais.

Bien entendu, les exemples ci-dessus de réalisation d'un circuit à retard asymétrique ne sont pas limitatifs et un circuit à retard Di peut utiliser tout type de cellule à retard logique (suite de portes, ...) ou analogique (charge et décharge de capacité) connu.

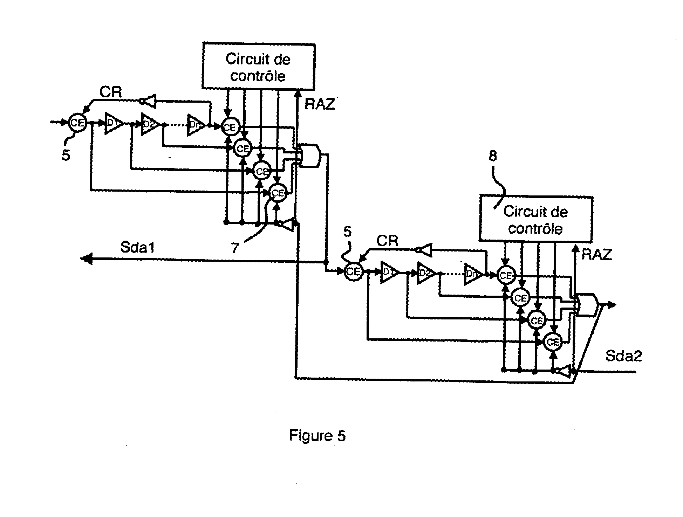

Pour accroître le débit à l'entrée indépendamment des valeurs Min, Max et de P, il est possible de connecter en série au moins deux circuits d'insertion de délai (structure du type pipeline). À titre d'exemple, la figure 5 comporte deux circuits d'insertion de délai selon la figure 2, connectés en série, la sortie d'un premier circuit d'insertion de délai étant reliée à l'entrée d'un second circuit d'insertion de délai. La valeur Min correspond alors à la somme des délais minimum de chaque circuit d'insertion de délai et la valeur Max à la somme des délais les plus longs pour chaque circuit d'insertion de délai. La sortie du second circuit d'insertion de délai est reliée à au moins une entrée de blocage du premier circuit, utilisée pour bloquer la propagation du signal du premier circuit d'insertion de délai dans le second circuit d'insertion de délai tant que le signal n'a pas été propagé à la sortie du second circuit. Ce blocage est, de préférence, réalisé par une contre-réaction entre la sortie du second circuit d'insertion de délai et le premier circuit d'insertion de délai. La sortie du premier circuit d'insertion de délai est réliée à une entrée du circuit asynchrone dont il fait partie, permettant la propagation d'un signal d'acquittement Sda1 au circuit asynchrone pour l'informer que le signal a bien été propagé par le premier circuit d'insertion de délai et que ce premier circuit d'insertion de délai est prêt à recevoir une nouvelle transition à l'entrée de sa porte de Muller 5. Dans le mode de réalisation particulier de la figure 5, la sortie du second circuit d'insertion de délai est reliée directement au circuit de contrôle 8 et par l'intermédiaire d'un inverseur, à une entrée supplémentaire de chaque porte de Muller 7 du circuit de multiplexage du premier circuit d'insertion de délai. Ainsi, une transition n'est pas présentée à l'entrée du second circuit d'insertion de délai tant que la transition en cours de propagation dans ce dernier n'a pas été propagée jusqu'à sa sortie. Dans ce mode de réalisation particulier, les portes de Muller 7 de chaque circuit de multiplexage comportent, de préférence, une entrée de remise à zéro (non représentée) cette entrée de remise à zéro permet (selon le même principe que l'entrée de remise à zéro de la porte de Muller 5) de mettre à 0 la sortie des portes de Muller 7 concernées. Lors de la mise à 0 des sorties des portes de Muller 7 du circuit de multiplexage du second circuit d'insertion de délai, la transition 0 est propagée au premier circuit d'insertion de délai par l'intermédiaire de l'inverseur à chaque entrée supplémentaire des portes de Muller 7 du premier circuit d'insertion de délai, permettant de mettre à 1 les entrées supplémentaires correspondantes. De même, la propagation de la transition 0 à la sortie du second circuit d'insertion de délai vers le circuit asynchrone, dont il fait partie, est acquittée au second circuit d'insertion de délai par un signal Sda2 propagé à l'entrée supplémentaire de chaque porte de Muller 7 du circuit de multiplexage du second circuit d'insertion de délai par l'intermédiaire d'un inverseur pour mettre à 1 chaque entrée supplémentaire correspondante. La remise à zéro des portes de Muller 7 du premier circuit d'insertion de délai permet de s'assurer qu'aucune des sorties des portes de Muller 7 est à 1, ce qui provoquerait la propagation de ce signal dans le second circuit d'insertion de délai (état non déterminé des signaux dans le cirucuit). Le pipe-line est ainsi initialisé et est prêt à recevoir à son entrée une transition 1 pour la propager. Cette remise à zéro permet l'initialisation du pipe-line et évite d'avoir un état indéterminé dans le pipe-fine.

De manière générale, afin que chaque circuit d'insertion de délai et ses composants soit placés dans un état stable, les différents signaux de remise à zéro sont appliqués pendant un certain temps jusqu'à l'obtention d'un d'état global stable du circuit.

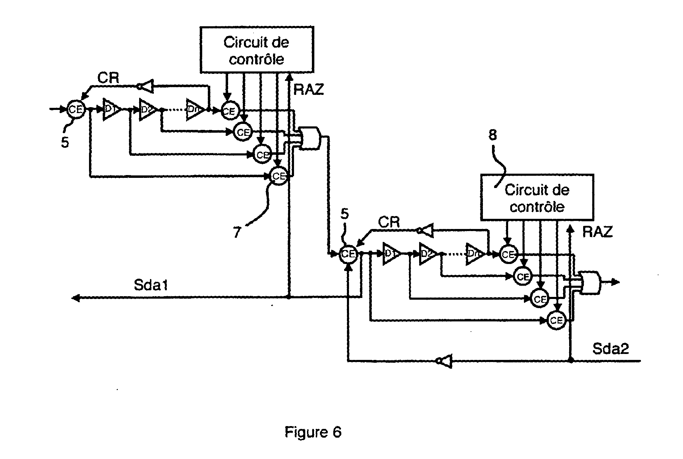

Dans une autre variante illustrée à la figure 6, le lien véhiculant le signal d'acquittement Sda2 du second circuit d'insertion de délai est relié directement au circuit de contrôle 8 et à une entrée supplémentaire de la porte de Muller 5 du second circuit d'insertion de délai par l'intermédiaire d'un inverseur afin de réaliser la contre-réaction empêchant la propagation d'un nouveau signal tant que le signal précédent n'a pas été propagé. Le lien véhiculant le signal d'acquittement Sda1 du premier circuit d'insertion de délai est non plus relié à la sortie du circuit de multiplexage du premier circuit d'insertion de délai mais à la sortie de la porte de Muller 5 du second circuit d'insertion de délai. De même, la sortie de la porte de Muller 5 du second circuit d'insertion de délai est reliée à l'entrée RAZ du circuit de multiplexage du premier circuit d'insertion de délai.

Dans une autre variante (non représentée), une porte de Muller additionnelle, effectuant la contre-réaction, peut être rajoutée entre la sortie du circuit de multiplexage du premier circuit d'insertion de délai et l'entrée de la porte de Muller d'entrée du second circuit d'insertion de délai.

Bien entendu, les variantes décrites ci-dessus ne sont que des exemples de réalisations. La structure en pipe-line peut être réalisée de multiple manières, tant que les principes de bases, à savoir connaître les différents états des circuits et envoyer une nouvelle transition à un circuit d'insertion de délai uniquement quand la transition précédente a quitté ledit circuit d'insertion de délai.

Le nombre de circuits d'insertion de délai connectés en série peut être supérieur à deux, une contre réaction entre la sortie de chaque circuit d'insertion de délai et le circuit de multiplexage du circuit d'insertion de délai précédent garantissant un blocage de la transition à l'entrée dudit circuit d'insertion de délai précédent jusqu'à ce que cette transition soit transmise à sa sortie.

Sur le principe du pipe-line, il est, bien entendu, possible de relier une pluralité de circuits d'insertions de délai en série.

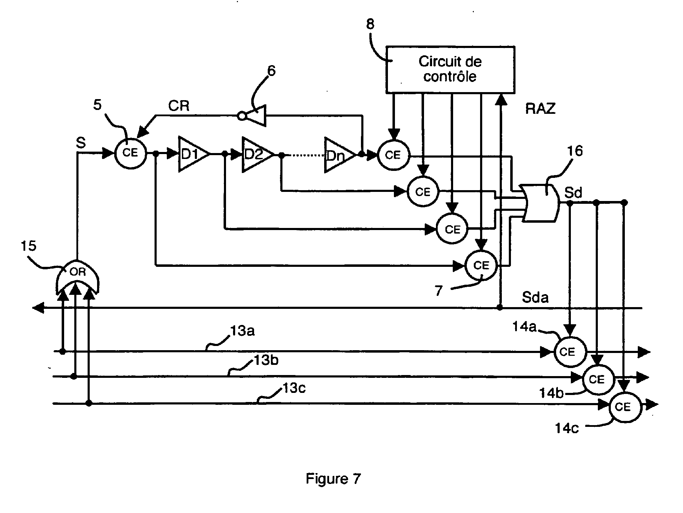

Comme illustré à la figure 7, le circuit d'insertion de délai de la figure 2 peut être utilisé dans un circuit asynchrone avec un canal multi-rails utilisant un codage 1 parmi n. Le canal multi-rails comporte plusieurs signaux de données 13 indépendants (trois signaux sur la figure 6, 13a, 13b et 13c). Chaque signal 13 est relié à une première entrée d'une porte de Muller 14 correspondante (14a, 14b, 14c). Un même circuit d'insertion de délai unique, illustré à la figure 2, est utilisé pour retarder les signaux. La sortie Sd du circuit d'insertion de délai est connectée à une seconde entrée de chaque porte de Muller 14. En amont des portes de Muller chaque signal 13 est relié à l'entrée S du circuit d'insertion de délai par l'intermédiaire d'une unique porte logique 15 de type OU. Le codage 1 parmi 3 implique ici, qu'à un instant donné, seul un des signaux véhicule une transition montante. Afin de réinitialiser le circuit d'insertion de délai entre chaque changement de signal de propagation d'une transition 1, le circuit asynchrone génère un signal d'acquittement Sda, ce signal provoque la mise à 0 de tous les signaux et permet de propager la transition 0 par la porte OU puis dans le circuit d'insertion de délai permettant de placer à 1 l'entrée CR de la porte de Muller 5.

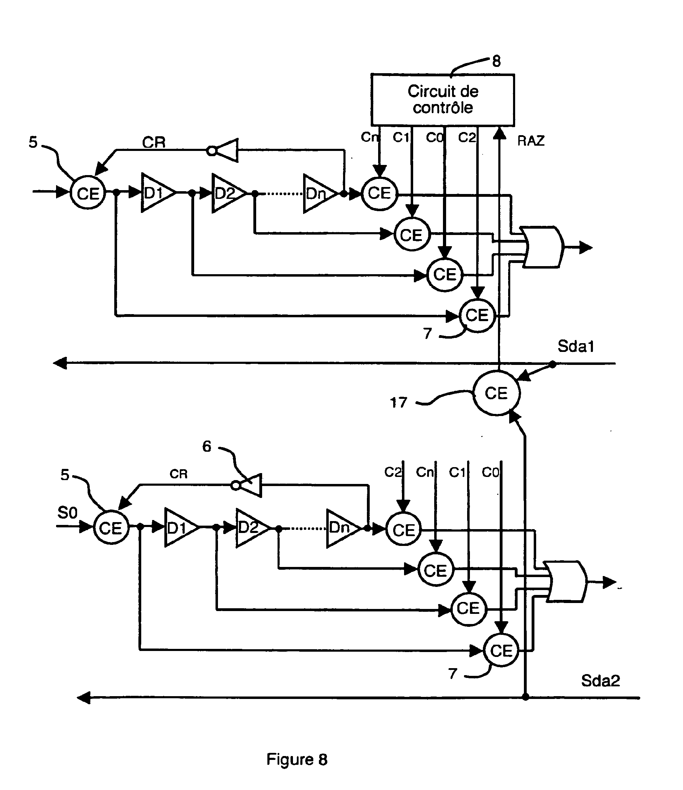

Dans une variante de réalisation, plusieurs circuits d'insertion de délais selon la figure 2 peuvent partager un même circuit de contrôle 8, qui contrôle les deux circuits de multiplexage des circuits d'insertion de délai, en permutant les liaisons (C0..Cn) entre le circuit de contrôle 8 et les différentes portes de Muller 7 des circuits de multiplexage des deux circuits d'insertion de délai. Dans l'exemple de réalisation illustré à la figure 8, la porte de Muller 7 du circuit de multiplexage du circuit d'insertion supérieur correspondant au délai D1 comporte une entrée reliée à la sortie C0 du contrôleur alors que cette même sortie C0 du contrôleur est reliée à la porte de Muller 7 correspondant à un délai quasi-nul du circuit de multiplexage du circuit d'insertion de délai inférieur. Par ailleurs, les sorties C1, C2 et Cn du circuit de contrôle 8 sont respectivement connectées à l'entrée des portes de Muller 7 connectées à la sortie du circuit à retard D2, de la porte de Muller 5 et du circuit à retard Dn du circuit d'insertion de délai supérieur, et à l'entrée des portes de Muller connectées à la sortie des circuits à retard D1, Dn et D2 du circuit d'insertion de délai inférieur. L'entrée remise à zéro (RAZ) du circuit de contrôle 8 est reliée à une sortie d'une porte de Muller 17 comportant autant d'entrées que de circuits d'insertion de délai associés au circuit de contrôle 8. Les signaux d'acquittement Sda1 et Sda2 correspondant à la validation, par le circuit asynchrone des transitions par chacun des circuits d'insertion de délai, sont appliqués aux entrées correspondantes de la porte de Muller 17. Ainsi, une nouvelle transition n'est envoyée à chacun des circuits d'insertion de délai qu'après propagation de la transition précédente avec le délai le plus élevé.

Dans tous les cas, la réalisation logique du retard généré par le circuit d'insertion de délai est telle que le retard est assuré indépendamment des délais des portes, des fils et des fourches isochrones (diffusion du signal dans deux branches distincte) qui constituent le circuit quasi-insensible aux délais. Le retard effectif peut donc être fluctuant, mais toutes les transitions présentées à l'entrée du circuit d'insertion de délai sont retardées et produites à la sortie du circuit d'insertion de délai sans perte.

L'invention n'est pas limitée aux exemples de réalisation décrits ci-dessus. En particulier, le circuit d'insertion de délai aléatoire ou cycliques peut être utilisé dans tout type de circuit asynchrone insensible aux délais, notamment les applications nécessitant une réduction du bruit ou dans les applications de sécurité utilisant des circuits de cryptage.

L'insertion de délais permet, dans un circuit asynchrone insensible aux délais, de garantir un bon fonctionnement même en présence de perturbations sur la latence des fils et des portes.

## Revendications

1. Circuit asynchrone insensible aux délais comportant, sur le chemin de propagation d'un signal, au moins un circuit d'insertion de délai, circuit asynchrone **caractérisé en ce que** le circuit d'insertion de délai comporte entre une entrée (S) et une sortie (Sd) du signal, une porte de Muller (5) et une pluralité de circuits à retard (Di ; D1, D2...Dn) connectés en série à une sortie de la porte de Muller (5), chaque circuit à retard comportant une sortie étant connectée à une entrée correspondante d'un circuit de multiplexage, une sortie du circuit de multiplexage constituant la sortie (Sd) du circuit d'insertion de délai, ladite porte de Muller (5) comportant une entrée constituant l'entrée (S) du circuit d'insertion de délai et une entrée connectée, par l'intermédiaire d'une porte inverseuse (6), à la sortie (Sn) du dernier circuit de retard (Dn).

2. Circuit asynchrone selon la revendication 1, **caractérisé en ce que** le circuit de multiplexage comporte au moins une entrée de contrôle (C0, C1, C2, Cn) reliée à un circuit de contrôle (8) comportant un générateur aléatoire ou pseudo-aléatoire.

3. Circuit asynchrone selon l'une des revendications 1 et 2, **caractérisée en ce que** les circuits à retard (7) du circuit d'insertion de délai sont de type symétriques et/ou asymétriques.

4. Circuit asynchrone selon l'une quelconque des revendications 1 à 3, **caractérisé en ce qu'**il comporte au moins des premier et second circuits d'insertion de délai connectés en série, la sortie du premier circuit d'insertion de délai étant connectée à l'entrée du second circuit d'insertion de délai, la sortie du second circuit d'insertion de délai étant connectée à au moins une entrée de blocage du circuit de multiplexage du premier circuit d'insertion de délai.

5. Circuit asynchrone selon l'une quelconque des revendications 1 à 3, **caractérisé en ce qu'**il comporte au moins deux circuits d'insertion de délai, les circuits de multiplexage des deux circuits d'insertion de délai étant reliés à un unique circuit de contrôle (8).

6. Circuit asynchrone selon l'une quelconque des revendications 1 à 3, **caractérisé en ce qu'**il comporte plusieurs signaux de données (13) indépendants, chaque signal (13a, 13b, 13c) étant connecté à une entrée d'un circuit d'insertion de délai unique et à une première entrée d'une porte de Muller additionnelle correspondante (14a, 14b, 14c), la sortie dudit circuit d'insertion de délai étant reliée à une seconde entrée de chaque porte de Muller additionnelle (14a, 14b, 14c).

## Claims

1. An asynchronous circuit insensitive to time delays comprising at least one delay insertion circuit on a signal propagation path, the asynchronous circuit **characterized in that** the delay insertion circuit comprises, between an input (S) and an output (Sd) of the signal, a Muller C-element (5) and a plurality of delay circuits (Di; D1, D2, ..., Dn) connected in series to an output of the Muller C-element (5), each delay circuit comprising an output connected to a corresponding input of a multiplexing circuit, an output of the multiplexing circuit constituting the output (Sd) of the delay insertion circuit, said Muller C-element (5) comprising an input constituting the input (S) of the delay insertion circuit and an input connected by means of an inverter gate (6) to the output (Sn) of the last delay circuit (Dn).

2. The asynchronous circuit according to claim 1, **characterized in that** the multiplexing circuit comprises at least one control input (C0, C1, C2, Cn) connected to a control circuit (8) comprising a random or pseudo-random generator.

3. The asynchronous circuit according to one of claims 1 and 2, **characterized in that** the delay circuits (7) of the delay insertion circuit are of symmetric and/or asymmetric type.

4. The asynchronous circuit according to anyone of claims 1 to 3, **characterized in that** it comprises at least first and second delay insertion circuits connected in series, the output of the first delay insertion circuit being connected to the input of the second delay insertion circuit, the output of the second delay insertion circuit being connected to at least one disable input of the multiplexing circuit of the first delay insertion circuit.

5. The asynchronous circuit according to anyone of claims 1 to 3, **characterized in that** it comprises at least two delay insertion circuits, the multiplexing circuits of the two delay insertion circuits being connected to a single control circuit (8).

6. The asynchronous circuit according to anyone of claims 1 to 3, **characterized in that** it comprises several independent data signals (13), each signal (13a, 13b, 13c) being connected to an input of a single delay insertion circuit and to a first input of a corresponding additional Muller C-element (14a, 14b, 14c), the output of said delay insertion circuit being connected to a second input of each additional Muller C-element (14a, 14b, 14c).

## Patentansprüche

1. Verzögerungsunempfindliche asynchrone Schaltung, die auf dem Ausbreitungsweg eines Signals mindestens eine Verzögerungszwischenschaltschaltung umfasst, asynchrone Schaltung, die **dadurch gekennzeichnet ist, dass** die Verzögerungszwischenschaltschaltung zwischen einem Eingang (S) und einem Ausgang (Sd) des Signals ein Muller-Gatter (5) und eine Mehrzahl von Verzögerungsschaltungen (Di ; D1, D2...Dn) aufweist, die in Serie an einen Ausgang des Muller-Gatters (5) gelegt sind, wobei jede Verzögerungsschaltung einen Ausgang umfasst, der an einen entsprechenden Eingang einer Multiplexschaltung gelegt ist, wobei ein Ausgang der Multiplexschaltung den Ausgang (Sd) der Verzögerungszwischenschaltschaltung bildet, welches Muller-Gatter (5) einen Eingang aufweist, der den Eingang (S) der Verzögerungszwischenschaltschaltung bildet, und einen Eingang, der mittels eines NICHT-Gatters (6) an den Ausgang (Sn) der letzten Verzögerungsschaltung (Dn) gelegt ist.

2. Asynchrone Schaltung nach Anspruch 1, **dadurch gekennzeichnet, dass** die Multiplexschaltung mindestens einen Steuereingang (C0, C1, C2, Cn) aufweist, der an eine Steuerschaltung (8) gelegt ist, die einen Zufalls- oder Pseudozufallsgenerator umfasst.

3. Asynchrone Schaltung nach einem der Ansprüche 1 und 2, **dadurch gekennzeichnet, dass** die Verzögerungsschaltungen (7) der Verzögerungszwischenschaltschaltung symmetrischer und/oder asymmetrischer Art sind.

4. Asynchrone Schaltung nach einem der Ansprüche 1 bis 3, **dadurch gekennzeichnet, dass** sie mindestens eine erste und eine zweite in Serie geschaltete Verzögerungszwischenschaltschaltung umfasst, wobei der Ausgang der ersten Verzögerungszwischenschaltschaltung an den Eingang der zweiten Verzögerungszwischenschaltschaltung gelegt ist, wobei der Ausgang der zweiten Verzögerungszwischenschaltschaltung an mindestens einen Blockierungseingang der Multiplexschaltung der ersten Verzögerungszwischenschaltschaltung gelegt ist.

5. Asynchrone Schaltung nach einem der Ansprüche 1 bis 3, **dadurch gekennzeichnet, dass** sie mindestens zwei Verzögerungszwischenschaltschaltungen umfasst, wobei die Multiplexschaltungen der beiden Verzögerungszwischenschaltschaltungen an eine einzige Steuerschaltung (8) gelegt sind.

6. Asynchrone Schaltung nach einem der Ansprüche 1 bis 3, **dadurch gekennzeichnet, dass** sie mehrere unabhängige Datensignale (13) umfasst, wobei jedes Signal (13a, 13b, 13c) an einen Eingang einer einzigen Verzögerungszwischenschaltschaltung und einen ersten Eingang eines entsprechenden zusätzlichen Muller-Gatters (14a, 14b, 14c) gelegt ist, wobei der Ausgang der genannten Verzögerungszwischenschaltschaltung an einen zweiten Eingang jedes zusätzlichen Muller-Gatters (14a, 14b, 14c) gelegt ist.
